# EUROPEAN PATENT APPLICATION

(11) **EP 4 780 190 A1**
(43) Date of publication of application: **22.07.2026**
(21) Application number: 24865215.8
(22) Date of filing: 26.08.2024

(54) **SEMICONDUCTOR RELAY**

(30) Priority: 11.09.2023 JP 2023146655
(71) Applicant: Panasonic Intellectual Property Management Co., Ltd., Kadoma-shi, Osaka 571-0057 (JP)
(72) Inventor: IKUTA, Masamichi, Kadoma-shi, Osaka 571-0057 (JP); UEDA, Nao, Kadoma-shi, Osaka 571-0057 (JP); YAMAMOTO, Shingo, Kadoma-shi, Osaka 571-0057 (JP)
(74) Representative: Grünecker Patent- und Rechtsanwälte PartG mbB
(86) International application number: PCT/JP2024/030253
(87) International publication number: WO 2025/057711

(57) **Abstract**

A semiconductor relay (100) includes a light-emitting element (10), a light-receiving element (20), first and second switching elements (31, 32), first and second die pads (51, 52), first and second terminals (41, 42), and a package (60) containing these components. The light-receiving element (20) is located between the first switching element (31) and the second switching element (32), below the light-emitting element (10). The first and second terminals (41, 42) have the other end connected to the first and second die pads (51, 52), respectively, and have the other end exposed outside the package (60). The first and second die pads (51, 52) at least partially overlap the first and second switching elements (31, 32), respectively, as viewed from above.

## Description

### Technical Field

The present disclosure relates to semiconductor relays.

### Background Art

As a means of signal transmission, a semiconductor relay, which is also called a metal-oxide-semiconductor field effect transistor (MOSFET) output photocoupler or a photo MOSFET, is conventionally known. This semiconductor relay typically achieves size reduction by sealing components thereof in a resin package.

For example, Patent Literature (PTL) 1 discloses a semiconductor relay including: a light-emitting element, an input-side terminal electrically connected to the light-emitting element; a light-receiving element positioned facing the light-emitting element; a first switching element electrically connected to the light-receiving element; a first lead including a first mount bed on which the first switching element is mounted and a first output-side terminal electrically connected to the first switching element; and a resin package that seals the light-emitting element, the light-receiving element, the first switching element, and the first mount bed of the first lead.

### Citation List

### Patent Literature

PTL 1: Unexamined Japanese Patent Publication No. 2022-126101

### Summary of Invention

In the existing semiconductor relay disclosed in PTL 1, the switching element generates substantial heat during operation. However, PTL 1 is silent regarding the measures for addressing this heat generation.

A semiconductor relay according to an aspect of the present disclosure includes: a light-emitting element; a light-receiving element located below the light-emitting element and facing the light-emitting element; a first switching element located adjacent to the light-receiving element; a second switching element located adjacent to the light-receiving element; a first die pad located above the first switching element; a second die pad located above the second switching element; a first terminal including one end connected to the first die pad; a second terminal including one end connected to the second die pad; and a package. The light-receiving element is located between the first switching element and the second switching element. A direction in which the first terminal and the second terminal are arranged is defined as a first direction. The other end of the first terminal is exposed outside the package and extends downward from the package. The other end of the second terminal is exposed outside the package and extends downward from the package. The light-emitting element, the light-receiving element, the first switching element, the second switching element, the first die pad, and the second die pad are located inside the package. The first die pad at least partially overlaps the first switching element as viewed from above. The second die pad at least partially overlaps the second switching element as viewed from above.

A semiconductor relay according to another aspect of the present disclosure includes: a light-emitting element; a light-receiving element located below the light-emitting element and facing the light-emitting element; a first switching element located adjacent to the light-receiving element; a second switching element located adjacent to the light-receiving element; a first die pad located above the first switching element; a second die pad located above the second switching element; a first terminal including one end connected to the first die pad; a second terminal including one end connected to the second die pad; and a package. The light-receiving element is located between the first switching element and the second switching element. A direction in which the first terminal and the second terminal are arranged is defined as a first direction. The other end of the first terminal is exposed outside the package and extends downward from the package. The other end of the second terminal is exposed outside the package and extends downward from the package. The first die pad at least partially overlaps the first switching element as viewed from above. The second die pad at least partially overlaps the second switching element as viewed from above. The semiconductor relay according to another aspect of the present disclosure further includes: a third die pad on which the first switching element is disposed; a fourth die pad on which the second switching element is disposed; a third terminal including one end connected to the third die pad; and a fourth terminal positioned facing the third terminal in the first direction. The light-emitting element, the light-receiving element, the first switching element, the second switching element, and the first to third die pads are located inside the package. The third terminal includes: a third leading end portion; a third intermediate portion connected to the third leading end portion and exposed outside the package; and a third connection portion located inside the package and connecting the third intermediate portion and the third die pad. The third intermediate portion includes: a first portion connected to the third connection portion; and a second portion extending downward from the first portion. When a direction in which the light-emitting element and the light-receiving element face each other is defined as a third direction, a minimum length of the third intermediate portion in the first direction is greater than a maximum length of the third leading end portion in the first direction, and a first axis is more distant from the fourth terminal than a second axis, the first axis being a center line of the first portion that extends in the third direction, the second axis being a center line of the third leading end portion that extends in the third direction.

According to the present disclosure, the path for dissipating the heat generated during the operation to the outside of the package can be enhanced, allowing for improved heat dissipation.

### Brief Description of Drawings

[Fig. 1A] Fig. 1A is an oblique projection of a semiconductor relay according to Embodiment 1.
[Fig. 1B] Fig. 1B is a side view of a semiconductor relay according to Embodiment 1, taken from the right.
[Fig. 1C] Fig. 1C is a side view of a semiconductor relay according to Embodiment 1, taken from the left.
[Fig. 1D] Fig. 1D is a top view of a semiconductor relay according to Embodiment 1.
[Fig. 1E] Fig. 1E is an oblique projection of the semiconductor relay according to Embodiment 1, with the package removed.
[Fig. 2] Fig. 2 is a top view of the semiconductor relay according to Embodiment 1, with the package removed.
[Fig. 3] Fig. 3 is a cross-sectional view of the semiconductor relay according to Embodiment 1, taken along line III-III in Fig. 2.
[Fig. 4] Fig. 4 is an equivalent circuit diagram of a semiconductor relay according to Embodiment 1.
[Fig. 5A] Fig. 5A is a bottom perspective view of the semiconductor relay according to Embodiment 1.
[Fig. 5B] Fig. 5B is a top perspective view of the semiconductor relay according to Embodiment 1.
[Fig. 6A] Fig. 6A is a plan view of a first die pad according to Embodiment 1.
[Fig. 6B] Fig. 6B is a plan view of a second die pad according to Embodiment 1.
[Fig. 6C] Fig. 6C is a plan view illustrating another example of the first die pad.
[Fig. 6D] Fig. 6D is a plan view illustrating yet another example of the first die pad.
[Fig. 7A] Fig. 7A is a plan view of a first die pad and a first switching element.
[Fig. 7B] Fig. 7B is a plan view of a second die pad and a second switching element.
[Fig. 8A] Fig. 8A is a top view of a first terminal according to Embodiment 1.
[Fig. 8B] Fig. 8B is a side view of a first terminal according to Embodiment 1.
[Fig. 9A] Fig. 9A is a top view of a first terminal according to a comparative example.
[Fig. 9B] Fig. 9B is a side view of a first terminal according to a comparative example.
[Fig. 10A] Fig. 10A is an enlarged view of the area enclosed by dashed line XA in Fig. 1C.
[Fig. 10B] Fig. 10B is an enlarged view of the area enclosed by dashed line XB in Fig. 1C.
[Fig. 11A] Fig. 11A is a Fig. 10A-equivalent view according to Variation 1.
[Fig. 11B] Fig. 11B is a Fig. 10B-equivalent view according to Variation 1.
[Fig. 12A] Fig. 12A is an oblique projection of a semiconductor relay according to Variation 2.
[Fig. 12B] Fig. 12B is a side view of a semiconductor relay according to Variation 2.
[Fig. 13] Fig. 13 is an oblique projection of a semiconductor relay according to Embodiment 2, with the package removed.

### Description of Embodiments

Hereinafter, exemplary embodiments of the present disclosure will be described in detail with reference to the drawings. The following description of preferred exemplary embodiments is essentially a mere example and is not at all intended to limit the present invention, the applicable range thereof, or the usage thereof.

In the present disclosure, the terms "up/upward/above/top" and "down/downward/below/bottom" do not indicate an upward direction (vertically upward) and a downward direction (vertically downward) in a sense of absolute space, but are used as terms defined by the relative positioning of elements included in the semiconductor relay. Furthermore, the terms "up/upward/above/top" and "down/downward/below/bottom" are applied not only to the case where two structural elements are positioned spaced apart from each other so that another structural element is placed between the two structural elements, but also to the case where two structural elements are positioned to adhere to each other so that the two structural elements are in contact. Note that in the following description, a view of semiconductor relay 100 and components thereof from above is referred to as a top view.

### (Embodiment 1)

### [Overall Configuration of Semiconductor Relay 100]

Hereinafter, semiconductor relay 100 according to Embodiment 1 will be described.

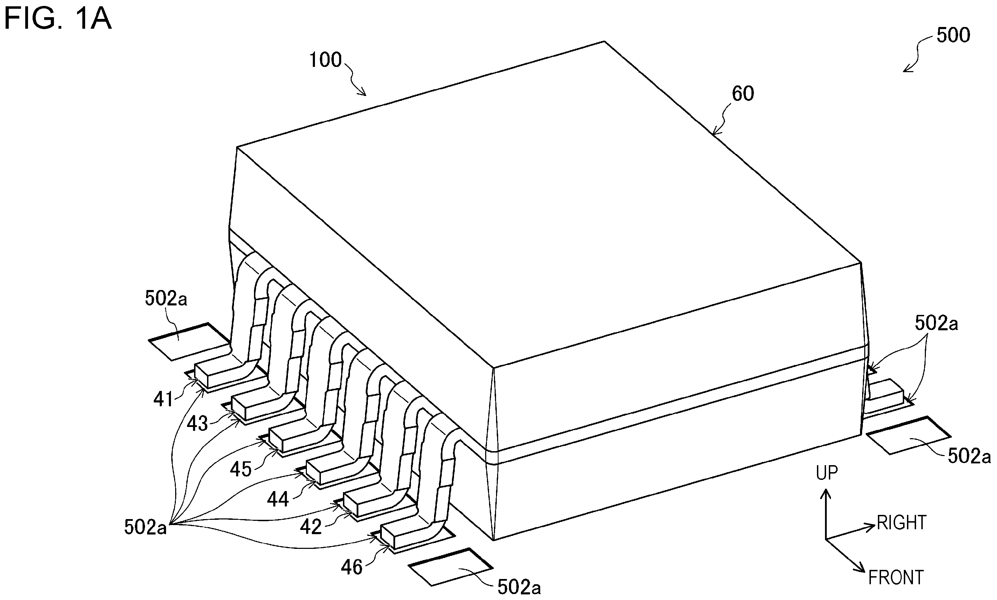

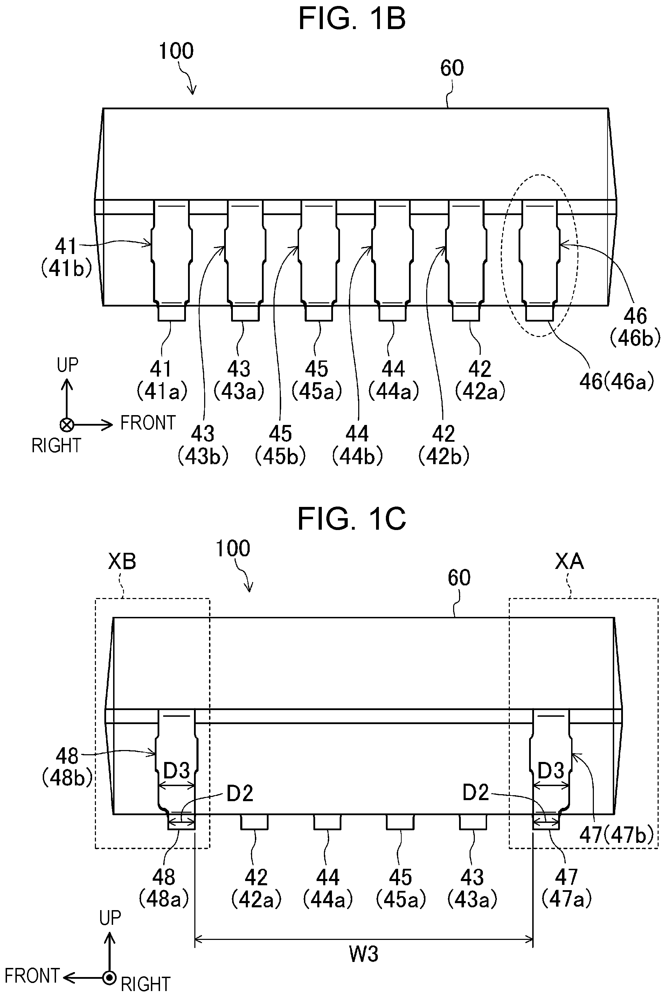

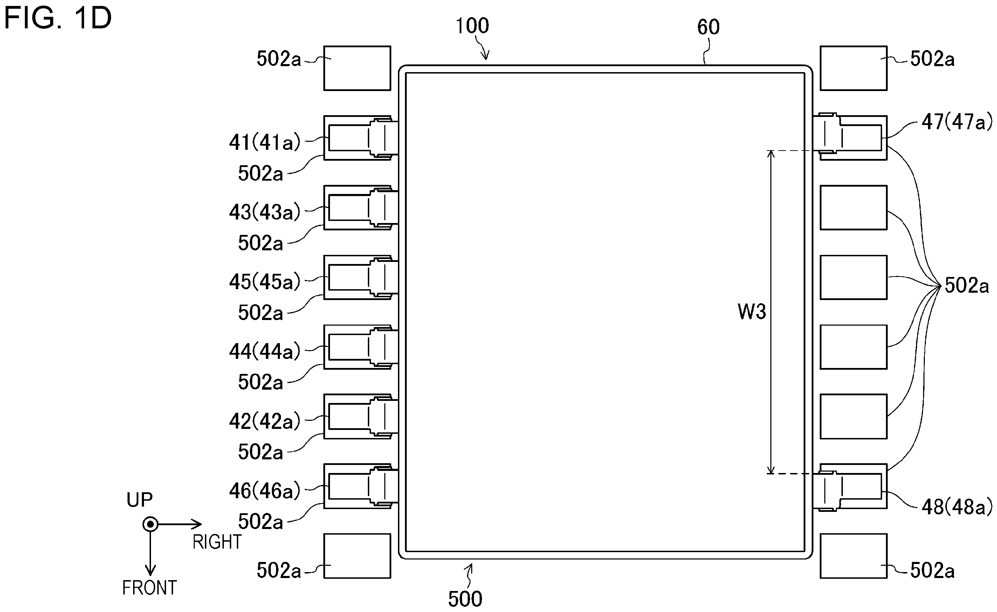

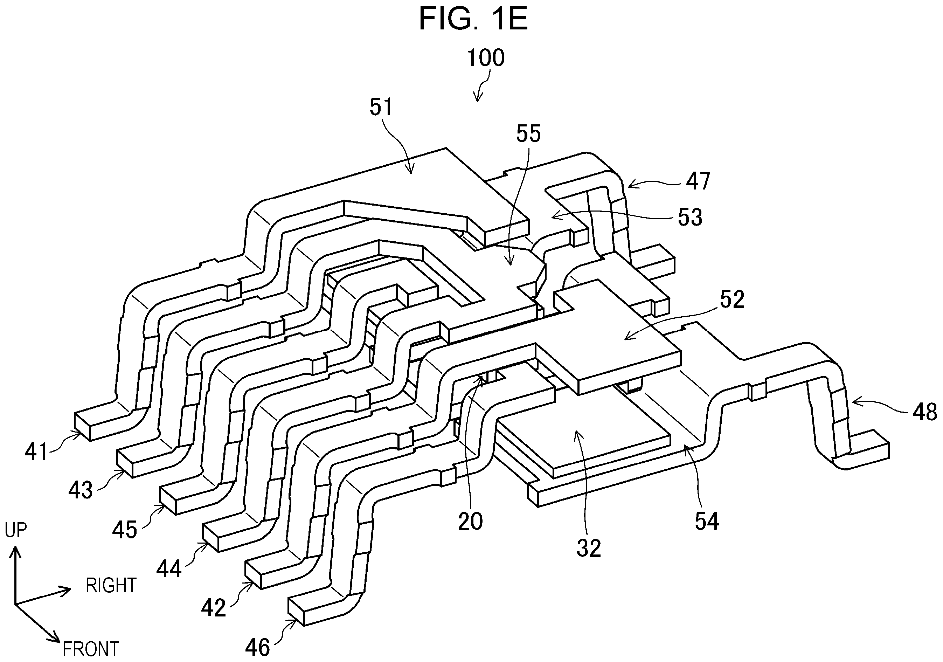

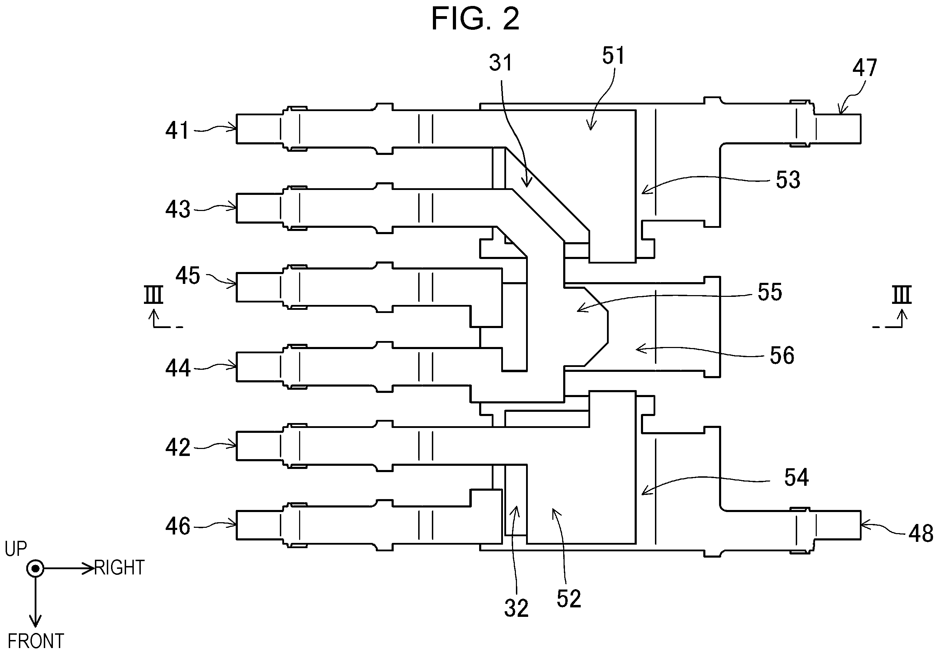

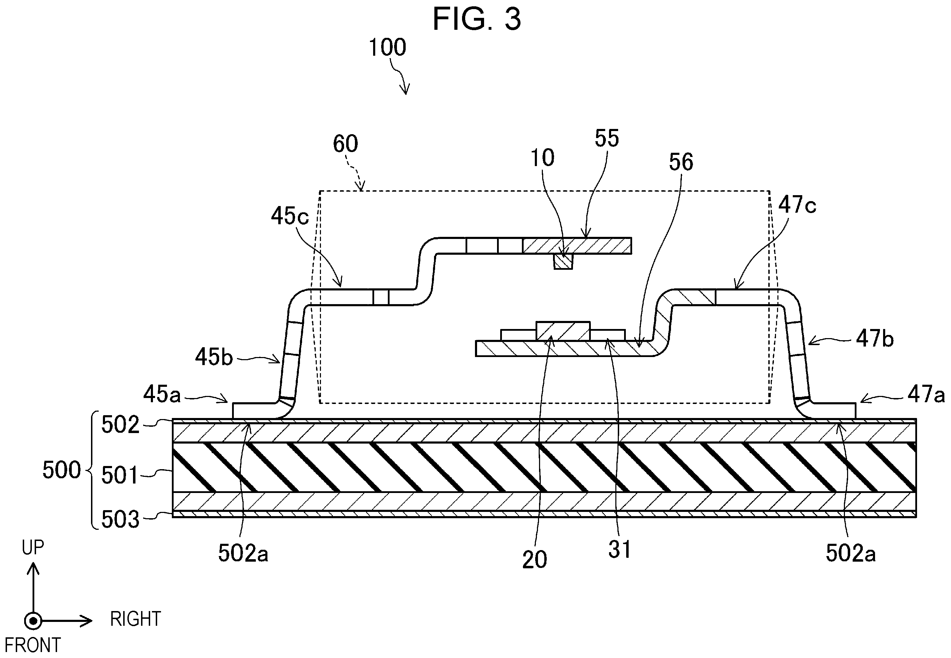

The general configuration of semiconductor relay 100 according to the present exemplary embodiment will be described with reference to Figs. 1 to 3. Fig. 1A is an oblique projection of a semiconductor relay according to Embodiment 1. Fig. 1B is a side view of the semiconductor relay according to Embodiment 1, taken from the right. Fig. 1C is a side view of the semiconductor relay according to Embodiment 1, taken from the left. Fig. 1D is a top view of the semiconductor relay according to Embodiment 1. Fig. 1E is an oblique projection of the semiconductor relay according to Embodiment 1, with the package removed. Fig. 2 is a top view of the semiconductor relay according to Embodiment 1. Fig. 3 is a cross-sectional view of the semiconductor relay according to Embodiment 1, taken along line III-III in Fig. 2.

Note that in Fig. 1A and subsequent figures, the illustration and detailed description of the metal wires connecting the components of semiconductor relay 100 are omitted for the sake of explanation. In Figs. 1A and 1D, only land 502a is illustrated among wires 502 provided on external mounting board 500.

In the following description, there are cases where the arrangement and configuration of the structural elements are described using the directional labels such as front, back, left, right, up, and down indicated in the drawings. Specifically, the direction in which terminal 42 is located with respect to terminal 41 is defined as the front or forward, and the direction in which terminal 41 is located with respect to terminal 42 is defined as the back or backward. The direction in which terminals 41 to 46 project is defined as the left or leftward, and the direction in which terminals 47 and 48 project is defined as the right or rightward. There are cases where the front-back direction is referred to as the first direction. There are cases where the left-right direction is referred to as the second direction. There are cases where the up-down direction is referred to as the third direction. The first to third directions are perpendicular to each other.

Note that there are cases where "terminal 41," "terminal 42," "terminal 47," and "terminal 48" are referred to as "first terminal 41," "second terminal 42," "seventh terminal 47," and "eighth terminal 48", respectively.

Note that "seventh terminal 47" in the exemplary embodiments corresponds to "the third terminal" in the claims, and "eighth terminal 48" in the exemplary embodiments corresponds to "the fourth terminal" in the claims.

Note that in the specification of the present application, the phrases "being perpendicular," "being parallel," and "being the same/equal" mean being perpendicular, being parallel, and being the same/equal including machining tolerances, erection tolerances, etc., of semiconductor relay 100 and components thereof; these phrases do not mean that targets to be compared are perpendicular to each other, parallel to each other, and the same as or equal to each other in a strict sense.

As illustrated in Figs. 1A to 3, semiconductor relay 100 incudes light-emitting element 10, light-receiving element 20, first and second switching elements 31, 32, first to sixth die pads 51 to 56, terminals 41 to 48, and package 60. First to sixth die pads 51 to 56 and terminals 41 to 48 are produced by machining a sheet of metal, such as copper.

Light-emitting element 10 is disposed on the lower surface of fifth die pad 55. Fifth die pad 55 is connected to terminal 43 and terminal 44. In the present exemplary embodiment, light-emitting element 10 is a light-emitting diode (LED).

Terminal 45 is electrically connected to light-emitting element 10 via a metal wire. When a predetermined voltage is applied between each of terminal 43 and terminal 44 and terminal 45, light-emitting element 10 emits light and outputs an optical signal.

Light-receiving element 20 is located below light-emitting element 10. Light-receiving element 20 is disposed on the upper surface of sixth die pad 56.

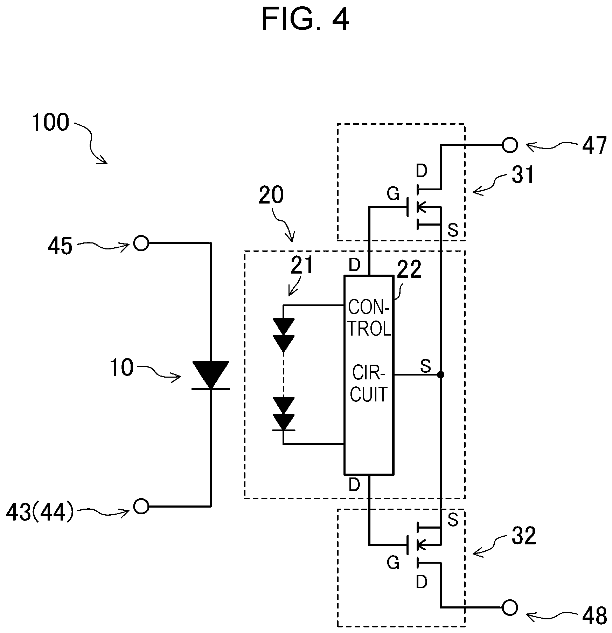

First and second switching elements 31, 32 are adjacent to light-receiving element 20. First and second switching elements 31, 32 are positioned on the opposite sides of light-receiving element 20 with spacing therebetween in the first direction. In other words, light-receiving element 20 is located between first and second switching elements 31, 32. In the present exemplary embodiment, each of first and second switching elements 31, 32 is a MOSFET (refer to Fig. 4), but this is not particularly limiting.

First switching element 31 is disposed on the upper surface of third die pad 53. Second switching element 32 is disposed on the upper surface of fourth die pad 54.

Third die pad 53 has one end connected to seventh terminal 47. Fourth die pad 54 has one end connected to eighth terminal 48.

Package 60, which is made from an insulating resin, seals light-emitting element 10, light-receiving element 20, first and second switching elements 31, 32, and first to sixth die pads 51 to 56. Furthermore, terminals 41 to 48 are partially sealed within package 60. In other words, light-emitting element 10, light-receiving element 20, first and second switching elements 31, 32, first to sixth die pads 51 to 56, and portions of terminals 41 to 48 are located inside package 60.

As illustrated in Figs. 1A to 1C, package 60 has a rectangular parallelepiped shape. Note that a projection or a recess may be provided on a side surface of package 60, although these features are not illustrated.

Although not illustrated, package 60 includes an insulating light-transmissive resin and an insulating light-blocking resin. The light-transmissive resin covers light-emitting element 10, light-receiving element 20, first and second switching elements 31, 32, first to sixth die pads 51 to 56, and portions of terminals 41 to 48 The light-blocking resin is provided to cover the entire surface of the light-transmissive resin.

First and second switching elements 31, 32 generate heat during the operation of semiconductor relay 100. When first and second switching elements 31, 32 generate heat, the internal temperature of entire package 60 increases. Consequently, package 60, which is a resin material, undergoes expansion, causing the elements to separate from package 60. Furthermore, light-emitting element 10, light-receiving element 20, and first and second switching elements 31, 32 separate from third to sixth die pads 53 to 56 accordingly. Moreover, the expansion of package 60 may lead to thermal runaway of the elements or cause the metal wires connecting the elements and third to sixth die pads 53 to 56 to fall off. This results in, for example, reduced reliability for light-emitting element 10, light-receiving element 20, and first and second switching elements 31, 32.

### [Operation of Semiconductor Relay 100]

Fig. 4 is an equivalent circuit diagram of the semiconductor relay according to Embodiment 1.

When an input signal is applied between terminal 43 and terminal 45 or between terminal 44 and terminal 45, light-emitting element 10 outputs an optical signal. The optical signal generated at light-emitting element 10 propagates through the inside of the light-transmissive resin and is received by light-receiving element 20.

Light-receiving element 20 includes photodiode array 21 and control circuit 22 connected in parallel to photodiode array 21. In photodiode array 21, an electric current is generated through photoelectric conversion, and control circuit 22 operates in response to that electric current. A drive signal, which is a voltage signal corresponding to the amount of light from light-emitting element 10, is applied to the gate electrode of first switching element 31 and the gate electrode of second switching element 32 through the metal wires.

When the drive signal voltage exceeds the threshold voltage of each of first switching element 31 and second switching element 32, the source (S)-drain (D) path of first switching element 31 and the source (S)-drain (D) path of second switching element 32 are switched ON. Furthermore, terminal 47 and terminal 48 are placed in a conducting state via first switching element 31 and second switching element 32. This allows for signal transmission between terminal 47 and terminal 48.

Note that there are cases where "terminal 47 (the third terminal)" and "terminal 48 (the fourth terminal)" are referred to as "seventh terminal 41" and "eighth terminal 48," respectively.

When the input signal stops between terminal 43 and terminal 45 or between terminal 44 and terminal 45, light-emitting element 10 stops emitting light. Consequently, photodiode array 21 no longer generates an electric current, and control circuit 22 stops operating.

As a result, the drive signal voltage applied to each of the gate electrode of first switching element 31 and the gate electrode of second switching element 32 drops. When the drive signal voltage falls below the aforementioned threshold voltage, the source (S)-drain (D) path of first switching element 31 and the source (S)-drain (D) path of second switching element 32 are switched OFF. Furthermore, the path between seventh terminal 47 and eighth terminal 48 is placed in a non-conducting state. This blocks signal transmission between seventh terminal 47 and eighth terminal 48.

### [Outline Configurations of First and Second Die Pads 51, 52]

First die pad 51 is located above first switching element 31. Second die pad 52 is located above second switching element 32. As illustrated in Fig. 3, semiconductor relay 100 is mounted on external mounting board 500, which is located at a lower level.

As illustrated in Fig. 3, external mounting board 500 includes main board 501, wires 502, and ground electrode 503. Main board 501 is made from a dielectric material, the plurality of wires 502 are formed on the upper surface of main board 501, and ground electrode 503 is formed on the lower surface of main board 501. Among the plurality of wires 502, wire 502 having one end with land 502a is a connecting wire used for connection to semiconductor relay 100 or other electronic components than semiconductor relay 100. The leading end portions of terminals 41 to 48, namely, leading end portions 41a to 48a, are connected to land 502a via an electrically conductive adhesive material not illustrated in the drawings. During the operation of semiconductor relay 100, the heat generated by semiconductor relay 100, particularly, first and second switching elements 31, 32, propagate to external mounting board 500, and external mounting board 500 generates heat.

Note that there are cases where "leading end portion 41a," "leading end portion 42a," "leading end portion 47a," and "leading end portion 48a" are referred to as "first leading end portion 41a," "second leading end portion 42a," "seventh leading end portion 47a," and "eighth leading end portion 48a," respectively.

Note that "seventh leading end portion 47a" in the exemplary embodiments corresponds to "the third leading end portion" in the claims, and "eighth leading end portion 48a" in the exemplary embodiments corresponds to "the fourth leading end portion" in the claims.

Next, the path through which the heat generated by first and second switching elements 31, 32 is dissipated to the outside will be described in more detail.

Part of the heat generated by first switching element 31 is dissipated to external mounting board 500 via third die pad 53 and seventh terminal 47. Furthermore, part of the heat generated by first switching element 31 is diffused upward through package 60 and absorbed by first die pad 51. Part of the heat absorbed by first die pad 51 is diffused to external mounting board 500 via first terminal 41. Furthermore, part of the heat absorbed by first die pad 51 is diffused upward through package 60 and dissipated to the outside through the upper surface of package 60.

As illustrated in Fig. 2, one end of first terminal 41 is connected to first die pad 51 inside package 60. The other end of first terminal 41 is exposed outside package 60. This configuration allows the heat absorbed by first die pad 51 to be dissipated to the outside of package 60 through first terminal 41.

Part of the heat generated by second switching element 32 is dissipated to external mounting board 500 via fourth die pad 54 and eighth terminal 48. Furthermore, part of the heat generated by second switching element 32 is diffused upward via package 60 and absorbed by second die pad 52. Part of the heat absorbed by second die pad 52 is diffused to external mounting board 500 via second terminal 42. Furthermore, part of the heat absorbed by second die pad 52 is diffused upward via package 60 and dissipated to the outside through the upper surface of package 60.

As illustrated in Fig. 2, one end of second terminal 42 is connected to second die pad 52. The other end of second terminal 42 is exposed outside package 60. This configuration allows the heat absorbed by second die pad 52 to be dissipated to the outside of package 60 through second terminal 42.

Note that second die pad 52 may be further connected to terminal 46. This configuration allows the heat absorbed by second die pad 52 to be dissipated to the outside of package 60 through not only second terminal 42, but also terminal 46.

The electronic components of semiconductor relay 100 are not disposed on first and second die pads 51, 52. This configuration prevents heat generated by first and second switching elements 31, 32 from affecting the operation of semiconductor relay 100, even when the heat is absorbed by first and second die pads 51, 52. Furthermore, the operational reliability of semiconductor relay 100 is not significantly affected. Note that a metal wire may be connected to each of first and second die pads 51, 52 to form part of a path through which the electric current flows inside semiconductor relay 100.

Generally, LEDs are more susceptible to heat than MOSFETs. Therefore, in the present exemplary embodiment, first die pad 51 carrying light-emitting element 10 is positioned at an upper level inside package 60, namely, on the side that provides high heat dissipation.

As illustrated in Fig. 2, first die pad 51 at least partially overlaps first switching element 31 as viewed from above. This configuration allows first die pad 51 to be close to first switching element 31, which is one of the heat sources. When first switching element 31 generates heat, the heat is diffused into the surroundings through the nearby resin. A reduced distance between first switching element 31 and first die pad 51 allows for increased heat conduction from first switching element 31 to first die pad 51. Thus, first die pad 51 can efficiently absorb the heat generated by first switching element 31. This configuration can enhance the path for dissipating heat generated during the operation of first switching element 31 to the outside of package 60.

In particular, this effect is pronounced when the components of semiconductor relay 100 are encapsulated by the resin, as in the present exemplary embodiment, because the resin has low thermal conductivity.

As illustrated in Fig. 2, second die pad 52 at least partially overlaps second switching element 32 as viewed from above. This configuration allows second die pad 52 to be close to second switching element 32, which is one of the heat sources. When second switching element 32 generates heat, the heat is diffused into the surroundings through the nearby resin. A reduced distance between second switching element 32 and second die pad 52 allows for increased heat conduction from second switching element 32 to second die pad 52. Thus, second die pad 52 can efficiently absorb the heat. This configuration can enhance the path for dissipating heat generated during the operation of second switching element 32 to the outside of package 60.

In particular, this effect is pronounced when the components of semiconductor relay 100 are encapsulated by the resin, as in the present exemplary embodiment, because the resin has low thermal conductivity.

### [Detailed Configurations of First and Second Die Pads 51, 52]

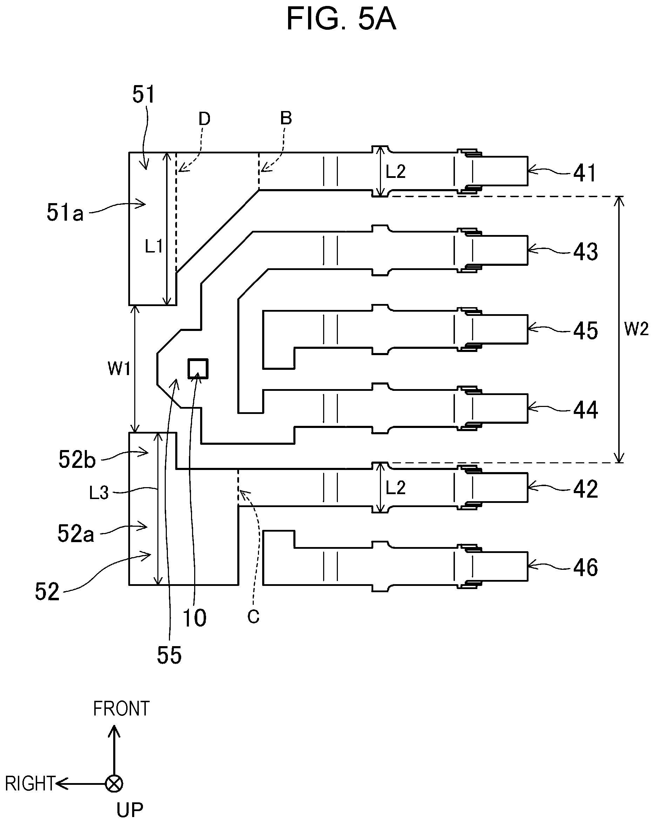

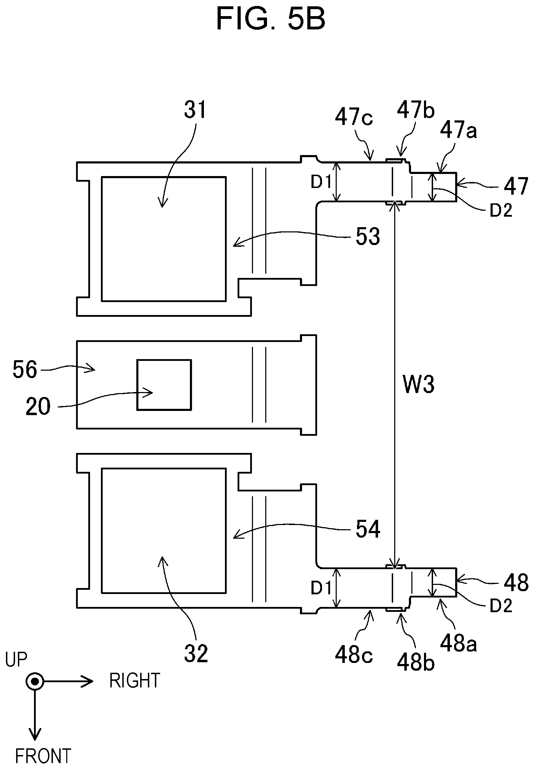

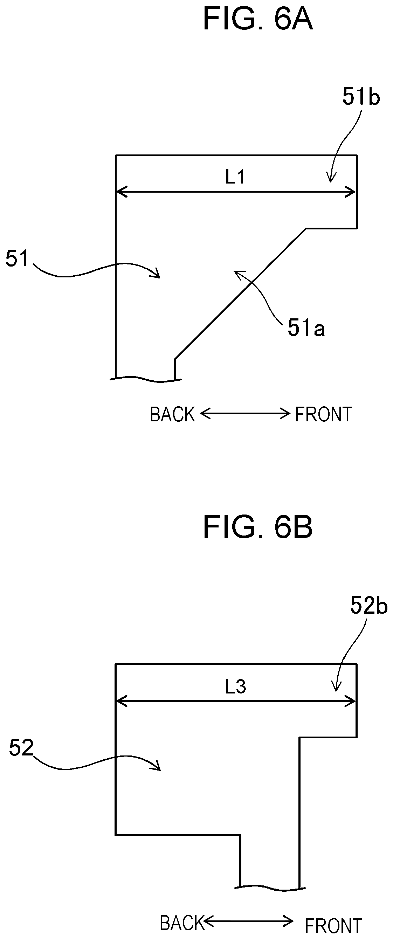

Fig. 5A is a bottom perspective view of the semiconductor relay according to the exemplary embodiment. Fig. 5B is a top perspective view of the semiconductor relay according to the exemplary embodiment. Hereinafter, the configurations of first and second die pads 51, 52 will be described in detail with reference to Fig. 5A in addition to Figs. 6A and 6B, which will be described later.

Dotted line B shown in Fig. 5A is the boundary between first die pad 51 and first terminal 41. Specifically, the portion of die pad 51 and first terminal 41 that begins to widen is the boundary between die pad 51 and first terminal 41.

Dotted line C shown in Fig. 5A is the boundary between second die pad 52 and second terminal 42. Specifically, the portion of second die pad 52 and second terminal 41 that begins to widen is the boundary between second die pad 52 and second terminal 42.

Maximum length L1 of first die pad 51 is greater than maximum length L2 of first terminal 41 in the front-back direction (the first direction). This configuration allows first die pad 51 to have a larger area than it would if the width of first die pad 51 were less than or equal to that of first terminal 41.

Maximum length L3 of second die pad 52 is greater than maximum length L2 of second terminal 42 in the front-back direction. In other words, second die pad 52 is wider than second terminal 42. This configuration allows second die pad 52 to have a larger area than it would if the width of second die pad 52 were less than or equal to that of second terminal 42.

Minimum distance W1 in the front-back direction between first die pad 51 and second die pad 52 is less than minimum distance W2 in the front-back direction between first terminal 41 and second terminal 42. When light-emitting element 10 is located between first and second die pads 51, 52, as in the present exemplary embodiment, first and second die pads 51, 52 can be provided close to light-emitting element 10, which is one of the heat sources. This configuration allows first and second die pads 51, 52 to efficiently absorb the heat generated by light-emitting element 10 and diffused into the surroundings.

First die pad 51 projects more backward than first terminal 41. In other words, first die pad 51 projects towards second die pad 52. First die pad 51 illustrated in Fig. 5A projects into an empty area inside package 60, where no components of semiconductor relay 100 are disposed. This configuration allows first die pad 51 to have a large area while the space inside package 60 is effectively used.

Second die pad 52 projects more forward than second terminal 42. In other words, second die pad 52 projects towards first die pad 51. Second die pad 52 illustrated in Fig. 5A projects into the aforementioned empty area inside package 60. This configuration allows second die pad 52 to have a large area while the space inside package 60 is effectively used.

As illustrated in Fig. 5A, first die pad 51 includes wide portion 51a. Wide portion 51a is configured such that the length of first die pad 51 in the front-back direction increases toward an end of first die pad 51, starting from the boundary between first terminal 41 and first die pad 51. This configuration allows first die pad 51 to have a large area while the space inside package 60 is effectively used. Here, wide portion 51a includes not only the portion of first die pad 51 ranging from dotted line B to dotted line D in Fig. 5A, but also the portion of first die pad 51 ranging from dotted line D to the end. In the following description, wide portion 51a may also be referred to as width changing portion 51a.

Second die pad 52 includes wide portion 52a. Wide portion 52a is configured such that the length of second die pad 52 in the front-back direction increases in the region ranging from the boundary between second terminal 42 and second die pad 52 to the end of second die pad 52. This configuration allows second die pad 52 to have a large area while the space inside package 60 is effectively used. In the following description, wide portion 52a may also be referred to as width changing portion 52a.

Fig. 6A is a plan view of the first die pad according to the present exemplary embodiment. As illustrated in Fig. 6A, the length of first die pad 51 in the front-back direction at the end of first die pad 51 is maximum length L1 of first die pad 51 in the front-back direction. The portion of wide portion 51a that has a rectangular shape projecting in the front-back direction is referred to as projecting portion 51b.

Fig. 6B is a plan view of the second die pad according to the present exemplary embodiment. As illustrated in Fig. 6B, the length of second die pad 52 in the front-back direction at the end of second die pad 52 is maximum length L3 of second die pad 52 in the front-back direction. The portion of second die pad 52 that has a rectangular shape projecting in the front-back direction is referred to as projecting portion 52b.

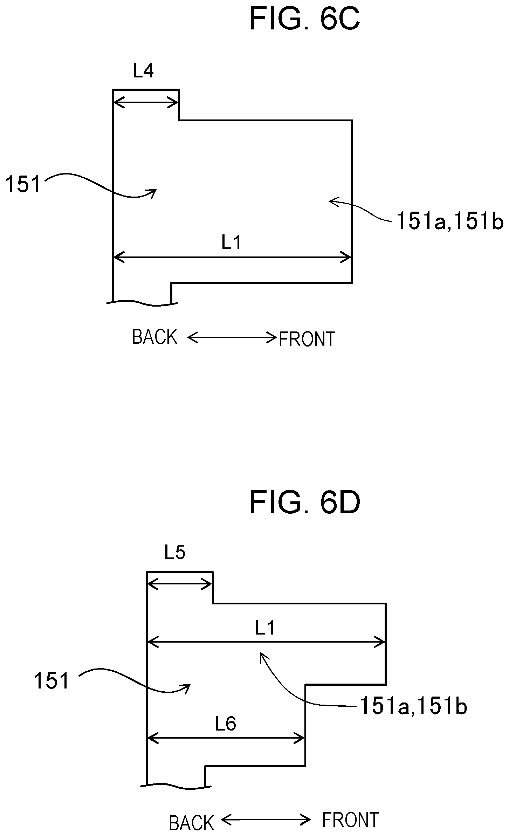

Note that the shape of first die pad 51 is not particularly limited to the shape illustrated in Figs. 1E, 2, and 5A and may, for example, be the shape illustrated in Fig. 6C or Fig. 6D.

Fig. 6C is a plan view illustrating another example of first die pad 51. As illustrated in Fig. 6A, the length of first die pad 51 in the front-back direction at the end of first die pad 51 is maximum length L1 of first die pad 51 in the front-back direction. In contrast, in first die pad 151 illustrated in Fig. 6C, length L4 of first die pad 151 in the front-back direction at the end of first die pad 151 is not maximum length L1 of first die pad 151 in the front-back direction. Wide portion 151a illustrated in Fig. 6C can also be referred to as projecting portion 151b projecting in the front-back direction or the left-right direction.

Fig. 6D is a plan view illustrating yet another example of the first die pad. First die pad 151 illustrated in Fig. 6D has a front-back width changing stepwise. A plurality of wide portions 151a illustrated in Fig. 6D can be referred to as a plurality of projecting portions 151b projecting in the front-back direction or the left-right direction. In the example illustrated in Fig. 6D, length L5 of first die pad 151 in the front-back direction at the right end of first die pad 151 is less than length L6 of first die pad 151 in the front-back direction at the left end of first die pad 151. Furthermore, length L6 is less than maximum length L1 of first die pad 151 in the front-back direction.

First die pad 51 (151) is preferably configured to have the largest possible area while maintaining the required insulation distance from nearby members. As the width of first die pad 51 (151) increases, semiconductor relay 100 provides higher heat dissipation. The reasons for this will be discussed in detail below.

When first die pad 51 is wide, the surface area and the volume of first die pad 51, which is made of metal, can be larger inside package 60 than when first die pad 51 is narrow. Thus, first die pad 51 can efficiently absorb the internal heat of package 60. The heat absorbed by first die pad 51 is released to the outside of package 60 through first terminal 41. First die pad 51 absorbs a larger amount of heat and further transfers the heat to first terminal 41, resulting in an increase in the amount of heat that can be released to the outside of package 60 through first terminal 41. Therefore, when first die pad 51 is wide, higher heat dissipation can be provided than when first die pad 51 is narrow.

Second die pad 52 is preferably configured to have the largest possible area while maintaining the required insulation distance from nearby members. As the width of second die pad 52 increases, semiconductor relay 100 provides higher heat dissipation. The reasons for this will be discussed in detail below.

When second die pad 52 is wide, the surface area and the volume of metal can be larger inside package 60 than when second die pad 52 is narrow. Thus, second die pad 52 can efficiently absorb the internal heat of package 60. The heat absorbed by second die pad 52 is released to the outside of package 60 through second terminal 42. Second die pad 52 absorbs a larger amount of heat and further transfers the heat to second terminal 42, resulting in an increase in the amount of heat that can be released to the outside of package 60 through second terminal 42. Therefore, when second die pad 52 is wide, higher heat dissipation can be provided than when second die pad 52 is narrow.

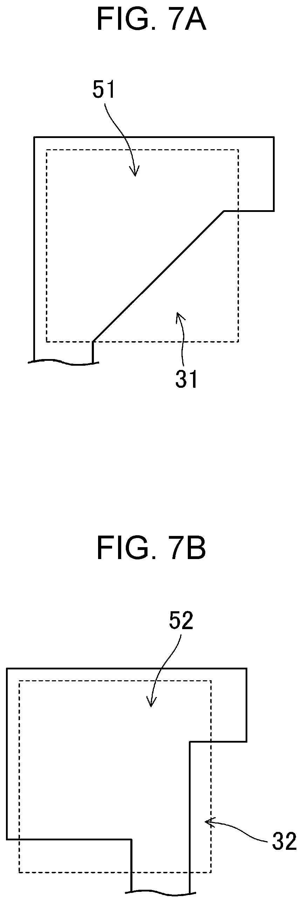

Fig. 7A is a plan view of the first die pad and the first switching element. Fig. 7B is a plan view of the second die pad and the second switching element. As illustrated in Figs. 7A and 7B, the area of first die pad 51 that overlaps first switching element 31 as viewed from above differs from the area of second die pad 52 that overlaps second switching element 32 as viewed from above. Furthermore, the shape of first die pad 51 differs from the shape of second die pad 52. With this configuration, the heat dissipation efficiency of first die pad 51 and the heat dissipation efficiency of second die pad 52 can be differentiated.

For example, in the present exemplary embodiment, the area of first die pad 51 overlapping first switching element 31 is smaller than the area of second die pad 52 overlapping second switching element 32. Therefore, second die pad 52 can absorb a larger amount of heat than first die pad 51. As a result, first switching element 31, which faces first die pad 51 in the up-down direction, has a lower temperature than first switching element 31, which faces first die pad 51 in the up-down direction. With this configuration, a heat-sensitive element can be installed in the front area of package 60 when package 60 is mounted on external mounting board 500.

### [Configurations of Terminals 41 to 46]

As illustrated in Fig. 1A to Fig. 2, terminals 41 to 46 are arranged in the first direction in the following order: terminal 41, terminal 43, terminal 45, terminal 44, terminal 42, and terminal 46. As is clear from Figs. 1A, 1E, and 2, terminals 41 to 46 are bent downward inside package 60, extend to the left, and are exposed outside package 60. Furthermore, terminals 41 to 46 extend downward along an outer side surface of package 60 outside package 60. Moreover, terminals 41 to 46 are bent to the left. In the present exemplary embodiment, the sections of terminals 41 to 46 that extend after being bent downward inside package 60 have the same shape. Next, the configurations of terminals 41, 42 will be described.

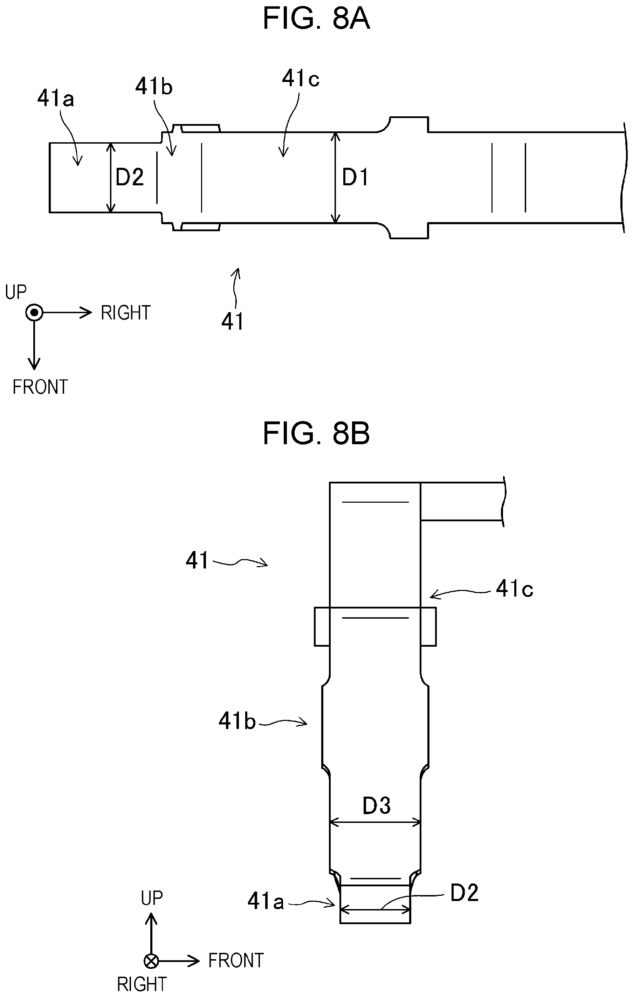

Fig. 8A is a top view of the first terminal according to Embodiment 1. Fig. 8B is a side view of the first terminal according to Embodiment 1. As illustrated in Figs. 1B, 8A, and 8B, first terminal 41 includes first leading end portion 41a, first intermediate portion 41b, and first connection portion 41c.

Note that there are cases where "leading end portion 41a," "intermediate portion 41b," and "connection portion 41c" are referred to as "first leading end portion 41a," "first intermediate portion 41b," and "first connection portion 41c," respectively.

As illustrated in Figs. 1A to 1D, first terminal 41 is mounted on external mounting board 500 via first leading end portion 41a. First leading end portion 41a is the portion of first terminal 41 that is exposed outside package 60 and extends parallel to the lower surface of package 60. First intermediate portion 41b is the portion of first terminal 41 that is connected to first leading end portion 41a and exposed outside package 60. First connection portion 41c is the portion of first terminal 41 that connects first intermediate portion 41b and first die pad 51 and is located inside package 60.

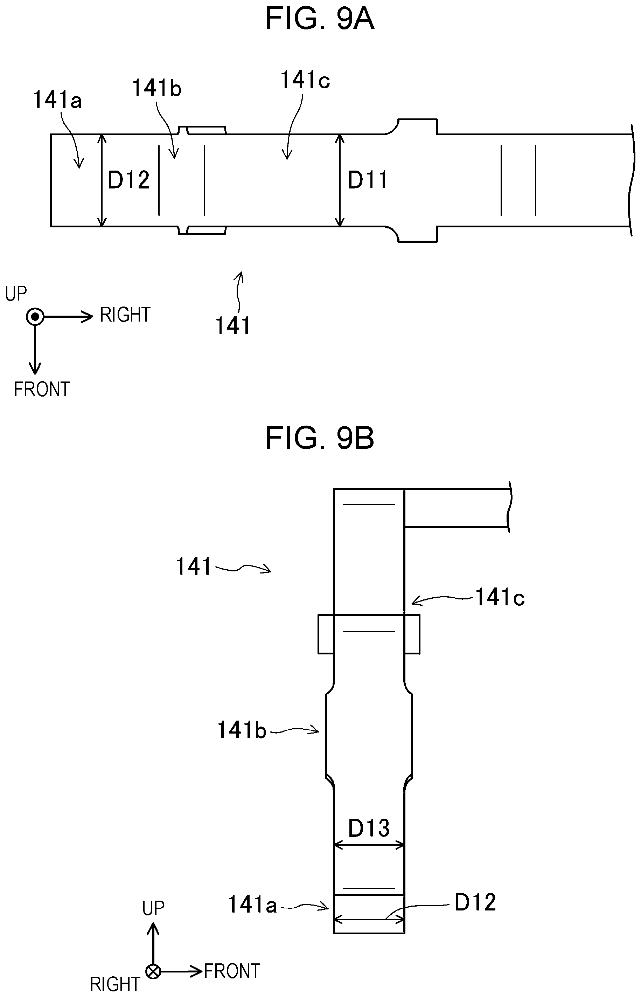

Fig. 9A is a top view of a first terminal according to a comparative example. Fig. 9B is a side view of the first terminal according to the comparative example. Next, the shape of first terminal 41 according to the present exemplary embodiment will be described in detail by comparison with first terminal 141 according to the comparative example.

As illustrated in Fig. 8A, in first terminal 41, minimum length D1 of first connection portion 41c in the front-back direction is greater than maximum length D2 of first leading end portion 41a in the front-back direction. In contrast, as illustrated in Fig. 9A, in first terminal 141, minimum length D11 of first connection portion 141c is equal to maximum length D12 of first leading end portion 141a in the front-back direction. Each of lengths D2, D12 of first leading end portion 41a and first leading end portion 141a in the front-back direction corresponds to the length of the land of external mounting board 500 in the front-back direction; length D2 is equal to length D12.

This means that first terminal 41 can provide higher heat dissipation outside package 60 than first terminal 141.

Next, the heat dissipation of first connection portion 41c according to the present disclosure will be described in more detail by comparison with first connection portion 141c according to the comparative example.

First connection portion 41c according to the present disclosure can have a larger surface area inside package 60 than first connection portion 141c according to the comparative example. Therefore, first connection portion 41c according to the present disclosure can more efficiently absorb the internal heat of package 60 than first connection portion 141c according to the comparative example. First connection portion 41c absorbs a larger amount of heat, resulting in an increase in the amount of heat that can be released to the outside of package 60.

First connection portion 41c according to the present disclosure can have a larger volume inside package 60 than first connection portion 141c according to the comparative example. Thus, first connection portion 41c according to the present disclosure can exhibit higher thermal conductivity than first connection portion 141c according to the comparative example. The heat absorbed by first die pad 51 is transferred through first connection portion 41c to first intermediate portion 41b exposed outside package 60. Furthermore, the heat absorbed by first connection portion 41c is transferred to first intermediate portion 41b exposed outside package 60. First connection portion 41c absorbs a larger amount of heat and further transfers the heat to first intermediate portion 41b exposed outside package 60, resulting in an increase in the amount of heat that can be released to the outside of package 60. Therefore, first connection portion 41c according to the present disclosure can provide higher heat dissipation than first connection portion 141c according to the comparative example.

As illustrated in Fig. 8B, minimum length D3 of first intermediate portion 41b is greater than maximum length D2 of first leading end portion 41a in the front-back direction. In contrast, as illustrated in Fig. 9B, minimum length D13 of first intermediate portion 141b is equal to maximum length D12 of first leading end portion 141a in the front-back direction. With this configuration, first terminal 41 can provide higher heat dissipation than first terminal 141.

Next, the heat dissipation of first intermediate portion 41b according to the present disclosure will be described in more detail by comparison with first intermediate portion 141b according to the comparative example.

First intermediate portion 41b according to the present disclosure illustrated in Fig. 8B can have a larger surface area than first intermediate portion 141b according to the comparative example illustrated in Fig. 9B. In other words, first intermediate portion 41b according to the present disclosure has a larger area exposed to the outside air than first intermediate portion 141b according to the comparative example. As a result, heat can be efficiently released from first intermediate portion 41b into the outside air.

First intermediate portion 41b according to the present disclosure can have a larger volume inside package 60 than first intermediate portion 141b according to the comparative example. Thus, first intermediate portion 41b according to the present disclosure can exhibit higher thermal conductivity than first intermediate portion 141b according to the comparative example. The heat absorbed by first die pad 51 is transferred to first intermediate portion 41b through first connection portion 41c. Furthermore, the heat absorbed by first connection portion 41c is transferred to first intermediate portion 41b. First intermediate portion 41b absorbs a larger amount of heat, resulting in an increase in the amount of heat that can be released to the outside of package 60. Thus, first intermediate portion 41b according to the present disclosure can provide higher heat dissipation than first intermediate portion 141b according to the comparative example.

As illustrated in Figs. 1B, 8A, and 8B, second terminal 42 includes second leading end portion 42a, intermediate portion 42b, and connection portion 42c.

Note that there are cases where "leading end portion 42a," "intermediate portion 42b," and "connection portion 42c" are referred to as "second leading end portion 42a," "second intermediate portion 42b," and "second connection portion 42c," respectively.

As illustrated in Figs. 1A to 1D, second terminal 42 is mounted on external mounting board 500 via second leading end portion 42a. Second leading end portion 42a is the portion of second terminal 42 that is exposed outside package 60 and extends parallel to the lower surface of package 60. Second intermediate portion 42b is the portion of second terminal 42 that is connected to second leading end portion 42a and exposed outside package 60. Second connection portion 42c is the portion of second terminal 42 that connects second intermediate portion 42b and second die pad 52 and is located inside package 60.

Note that the configuration of second terminal 42 is substantially the same as first terminal 41 described with reference to Figs. 8A and 8B.

In second terminal 42, minimum length D1 of second connection portion 42c in the front-back direction is greater than maximum length D2 of second leading end portion 42a in the front-back direction. As described above for first terminal 41, this configuration allows for improved heat dissipation of second terminal 42.

Minimum length D3 of second intermediate portion 42b in the front-back direction is greater than maximum length D2 of second leading end portion 42a in the front-back direction. As described above for first terminal 41, this configuration allows for improved heat dissipation of second terminal 42.

### [Configurations of Seventh and Eighth Terminals 47, 48]

As described above, first and second switching elements 31, 32 generate heat. As illustrated in Figs. 1E and 2, first switching element 31 and second switching element 32 are mounted on third die pad 53 and fourth die pad 54, respectively, and third die pad 53 and fourth die pad 54 are connected to seventh terminal 47 and eighth terminal 48, respectively. This configuration allows the heat generated by first and second switching elements 31, 32 to be released from seventh and eighth terminals 47, 48 to the outside of package 60. As illustrated in Figs. 1C and 5B, seventh terminal 47 includes seventh leading end portion 47a, seventh intermediate portion 47b, and seventh connection portion 47c.

Note that "seventh terminal 47" in the exemplary embodiments corresponds to "the third terminal" in the claims, and "eighth terminal 48" in the exemplary embodiments corresponds to "the fourth terminal" in the claims.

Furthermore, "seventh leading end portion 47a," "seventh intermediate portion 47b," "seventh connection portion 47c" in the exemplary embodiments correspond to "the third leading end portion," "the third intermediate portion," and "the third connection portion" in the claims, respectively.

Moreover, "eighth leading end portion 48a," "eighth intermediate portion 48b," "eighth connection portion 48c" in the exemplary embodiments correspond to "the fourth leading end portion," "the fourth intermediate portion," and "the fourth connection portion" in the claims, respectively.

As illustrated in Figs. 1A to 1D, seventh terminal 47 is mounted on external mounting board 500 via seventh leading end portion 47a. Seventh leading end portion 47a is the portion that is exposed outside package 60 and extends parallel to the lower surface of package 60. Seventh intermediate portion 47b is the portion that is connected to seventh leading end portion 47a and exposed outside package 60. Seventh connection portion 47c is the portion that connects seventh intermediate portion 47b and third die pad 53 and is located inside package 60.

As illustrated in Fig. 5B, minimum length D1 of seventh connection portion 47c in the front-back direction is greater than maximum length D2 of seventh leading end portion 47a in the front-back direction. As described above for first terminal 41, this configuration allows for improved heat dissipation of seventh terminal 47, similar to first terminal 41.

As illustrated in Fig. 1C, minimum length D3 of seventh intermediate portion 47b in the front-back direction is greater than maximum length D2 of seventh leading end portion 47a in the front-back direction. As described above for first terminal 41, this configuration allows for improved heat dissipation of seventh terminal 47.

As illustrated in Figs. 1C and 5B, eighth terminal 48 includes eighth leading end portion 48a, eighth intermediate portion 48b, and eighth connection portion 48c.

As illustrated in Figs. 1A to 1D, eighth terminal 48 is mounted on external mounting board 500 via eighth leading end portion 48a. Eighth leading end portion 48a is the portion that is exposed outside package 60 and extends parallel to the lower surface of package 60. Eighth intermediate portion 48b is the portion that is connected to eighth leading end portion 48a and exposed outside package 60. Eighth connection portion 48c is the portion that connects eighth intermediate portion 48b and fourth die pad 54 and is located inside package 60.

As illustrated in Fig. 5B, minimum length D1 of eighth connection portion 48c in the front-back direction is greater than maximum length D2 of eighth leading end portion 48a in the front-back direction. As described above for first terminal 41, this configuration allows for improved heat dissipation of eighth terminal 48.

As illustrated in Fig. 1C, minimum length D3 of eighth intermediate portion 48b in the front-back direction is greater than maximum length D2 of eighth leading end portion 48a in the front-back direction. As described above for first terminal 41, this configuration allows for improved heat dissipation of eighth terminal 48.

Intermediate portions 41b to 46c have a lower portion that expands on both sides in the front-back direction as illustrated in Fig. 1B, whereas seventh and eighth intermediate portions 47b, 48b have a lower portion that expands on one side in the front-back direction as illustrated in Fig. 1C. Specifically, the lower portion of seventh intermediate portion 47b expands on the side distant from eighth intermediate portion 48b, which corresponds to the backward direction in this case. The lower portion of eighth intermediate portion 48b expands on the side distant from seventh intermediate portion 47b, which corresponds to the forward direction in this case.

To ensure sufficient insulation between first and second switching elements 31, 32, the creepage distance needs to be set large enough. Here, the creepage distance is the shortest distance along the surface of an insulating material between two conductive parts. In semiconductor relay 100, an electric discharge on the surface of package 60, which is made from resin, has a significant impact. Therefore, creepage distance W3 (refer to Figs. 1C and 5B) on the output side of semiconductor relay 100 corresponds to the minimum distance in the front-back direction between seventh terminal 47 and eighth terminal 48.

Since lands 502a are arranged at an equal pitch in the front-back direction, the positions of seventh and eighth leading end portions 47a, 48a cannot be changed. Therefore, as illustrated in Fig. 1C, the lower portions of seventh and eighth intermediate portions 47b, 48b expand only on the sides distant from each other, allowing for the minimum distance in the front-back direction between seventh leading end portion 47a and eighth leading end portion 48a to be set equal to creepage distance W3. As a result, creepage distance W3 can be kept from becoming short, thereby ensuring insulation between seventh terminal 47 and eighth terminal 48, and furthermore, between first switching element 31 and second switching element 32.

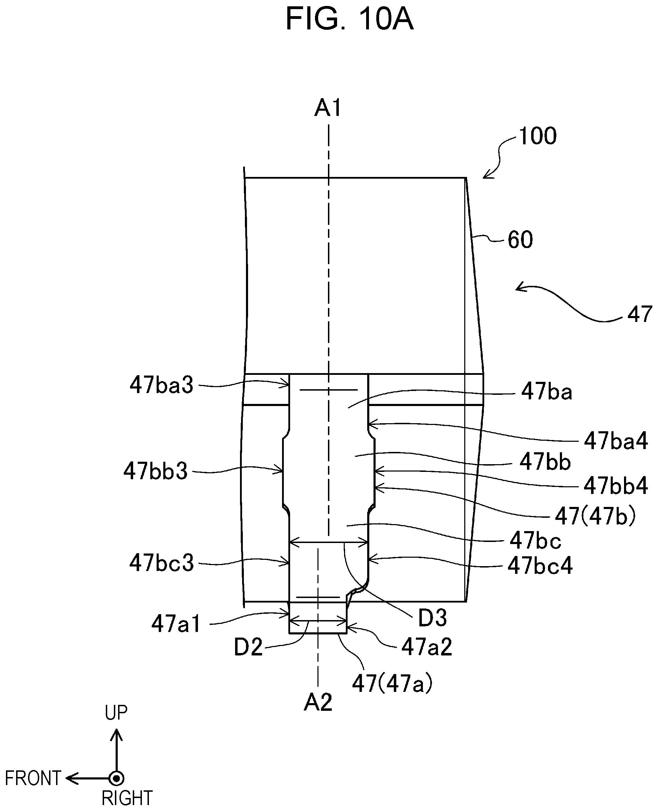

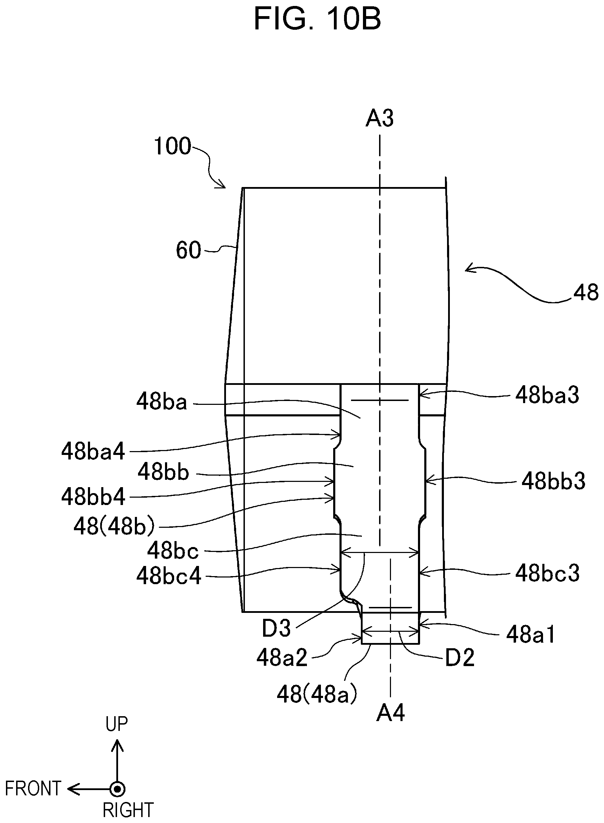

Semiconductor relay 100 in the present example is surface-mounted on external mounting board 500. Specifically, leading end portions 41a to 48a are surface-mounted on external mounting board 500 by extending parallel to and along the lower surface of package 60, outside package 60. Furthermore, in order to ensure creepage distance W3, the shape of each of seventh terminal 47 and eighth terminal 48 is defined in more detail. Fig. 10A is an enlarged view of the area enclosed by dashed line XA in Fig. 1C. Fig. 10B is an enlarged view of the area enclosed by dashed line XB in Fig. 1C.

As illustrated in Fig. 10A, the side surface of seventh leading end portion 47a of seventh terminal 47 that faces eighth terminal 48 is referred to as first surface 47a1, and the side surface of seventh leading end portion 47a of seventh terminal 47 that is opposite to first surface 47a1 in the front-back direction is referred to as second surface 47a2.

Seventh intermediate portion 47b of seventh terminal 47 is made up of a plurality of portions having corresponding shapes. Specifically, seventh intermediate portion 47b includes: first portion 47ba connected to seventh connection portion 47c; second portion 47bb extending downward from first portion 47ba; and third portion 47bc extending downward from second portion 47bb and connected to seventh leading end portion 47a. As illustrated in Fig. 10A, the length of third portion 47bc in the front-back direction corresponds to minimum length D3 of seventh intermediate portion 47b. The side surface of third portion 47bc that faces eighth terminal 48 in the front-back direction is referred to as third surface 47bc3, and the side surface of third portion 47bc that is opposite to third surface 47bc3 is referred to as fourth surface 47bc4.

Similarly, the side surfaces of first and second portions 47ba, 47bb that face eighth terminal 48 are referred to as third surfaces 47ba3, 47bb3, and the side surfaces of first and second portions 47ba, 47bb that are opposite to third surfaces 47ba3, 47bb3 are referred to as fourth surfaces 47ba4, 47bb4.

As illustrated in Fig. 10B, the side surface of eighth leading end portion 48a of eighth terminal 48 that faces seventh terminal 47 is referred to as fifth surface 48a1, and the side surface of eighth leading end portion 48a of eighth terminal 48 that is opposite to fifth surface 48a1 in the front-back direction is referred to as sixth surface 48a2.

Eighth intermediate portion 48b of eighth terminal 48 is made up of a plurality of portions having corresponding shapes. Specifically, eighth intermediate portion 48b includes: fourth portion 48ba connected to eighth connection portion 48c; fifth portion 48bb extending downward from fourth portion 48ba; and sixth portion 48bc extending downward from fifth portion 48bb and connected to eighth leading end portion 48a. As illustrated in Fig. 10B, the length of sixth portion 48bc in the front-back direction corresponds to minimum length D3 of eighth intermediate portion 48b. The side surface of sixth portion 48bc that faces seventh terminal 47 in the front-back direction is referred to as seventh surface 48bc3, and the side surface of sixth portion 48bc that is opposite to seventh surface 48bc3 is referred to as eighth surface 48bc4.

Similarly, the side surfaces of fourth and fifth portions 48ba, 48bb that face eighth terminal 48 in the front-back direction are referred to as seventh surfaces 48ba3, 48bb3, and the side surfaces of fourth and fifth portions 48ba, 48bb that are opposite to seventh surfaces 48ba3, 48bb3 are referred to as eighth surfaces 48ba4, 48bb4.

As illustrated in Fig. 10A, in seventh terminal 47, first axis A1, which is the up-down center line of first portion 47ba, is more distant from eighth terminal 48 in the front-back direction than second axis A2, which is the up-down center line of seventh leading end portion 47a. With this, the distance in the front-back direction between seventh intermediate portion 47b and eighth terminal 48 can be kept from becoming too short compared to the distance in the front-back direction between seventh leading end portion 47a and eighth terminal 48, and creepage distance W3 mentioned above can be secured.

Seventh terminal 47 is designed to have a shape such that first surface 47a1 of seventh leading end portion 47a and third surface 47bc3 of third portion 47bc of seventh intermediate portion 47b are flush with each other. As a result, the distance in the front-back direction between seventh intermediate portion 47b and eighth terminal 48 can be set equal to the distance in the front-back direction between seventh leading end portion 47a and eighth terminal 48 at the position near external mounting board 500, and creepage distance W3 mentioned above can be secured.

As illustrated in Fig. 10B, in eighth terminal 48, third axis A3, which is the up-down center line of fourth portion 48ba, is more distant from seventh terminal 47 in the front-back direction than fourth axis A4, which is the up-down center line of eighth leading end portion 48a. With this, the distance in the front-back direction between eighth intermediate portion 48b and seventh terminal 47 can be kept from becoming too short compared to the distance in the front-back direction between eighth leading end portion 48a and seventh terminal 47, and creepage distance W3 mentioned above can be secured.

Eighth terminal 48 is designed to have a shape such that fifth surface 48a1 of eighth leading end portion 48a and seventh surface 48bc3 of sixth portion 48bc of eighth intermediate portion 48b are flush with each other. As a result, the distance in the front-back direction between eighth intermediate portion 48b and seventh terminal 47 can be set equal to the distance in the front-back direction between eighth leading end portion 48a and seventh terminal 47 at the position near external mounting board 500, and creepage distance W3 mentioned above can be secured.

### <First Variation>

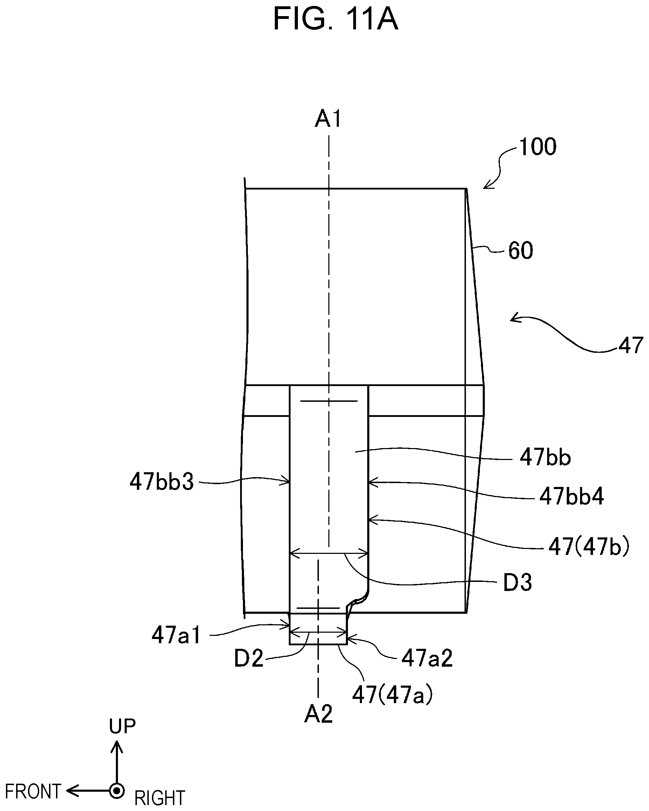

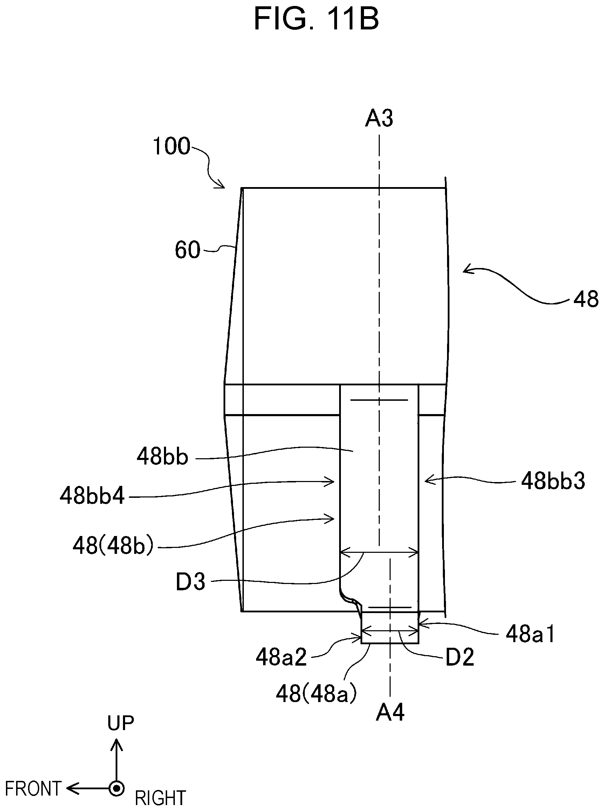

Fig. 11A is a Fig. 10A-equivalent view according to Variation 1. Fig. 11B is a Fig. 10B-equivalent view according to Variation 1. Note that in Figs. 11A, 11B and subsequent figures, elements substantially the same as those in Embodiment 1 are assigned the same reference signs, and a detailed description thereof is omitted.

Seventh terminal 47 illustrated in Fig. 11A is different from that in semiconductor relay 100 according to Embodiment 1 illustrated in Fig. 10A in that third surfaces 47ba3, 47bb3, 47bc3 of first to third portions 47ba, 47bb, 47bc are flush with each other. Furthermore, seventh terminal 47 illustrated in Fig. 11A is different from that in semiconductor relay 100 according to Embodiment 1 illustrated in Fig. 10A in that fourth surfaces 47ba4, 47bb4, 47bc4 of first to third portions 47ba, 47bb, 47bc of seventh intermediate portion 47b are flush with each other.

In other words, first to third portions 47ba, 47bb, 47bc can be regarded as one member that shares third surface 47bb3 and fourth surface 47bb4; in the present variation, seventh intermediate portion 47b will also be referred to as seventh intermediate portion 47bb. As viewed in the left-right direction, third surface 47bb3 of seventh intermediate portion 47bb is flush with first surface 47a1 of seventh leading end portion 47a.

Furthermore, eighth terminal 48 illustrated in Fig. 11B is different from that in semiconductor relay 100 according to Embodiment 1 illustrated in Fig. 10A in that seventh surfaces 48ba3, 48bb3, 48bc3 of fourth to sixth portions 48ba, 48bb, 48bc of eighth intermediate portion 48b are flush with each other. Eighth terminal 48 illustrated in Fig. 11B is different from that in semiconductor relay 100 according to Embodiment 1 illustrated in Fig. 10B in that eighth surfaces 48ba4, 48bb4, 48bc4 of fourth to sixth portions 48ba, 48bb, 48bc of eighth intermediate portion 48b are flush with each other.

In other words, fourth to sixth portions 48ba, 48bb, 48bc can be regarded as one member that shares seventh surface 48bb3 and eighth surface 88bb4; in the present variation, eighth intermediate portion 48b will also be referred to as eighth intermediate portion 48bb. As viewed in the left-right direction, seventh surface 48bb3 of eighth intermediate portion 48bb is flush with fifth surface 48a1 of eighth leading end portion 48a.

When seventh intermediate portion 47b and eighth intermediate portion 48b are configured as just described, the distance in the front-back direction between seventh terminal 47 and eighth terminal 48 can be set constant over the entire portions exposed outside package 60, and sufficient creepage distance W3 mentioned above can be secured. In the present variation, the spatial insulation distance between seventh terminal 47 and eighth terminal 48 can be secured.

### <Second Variation>

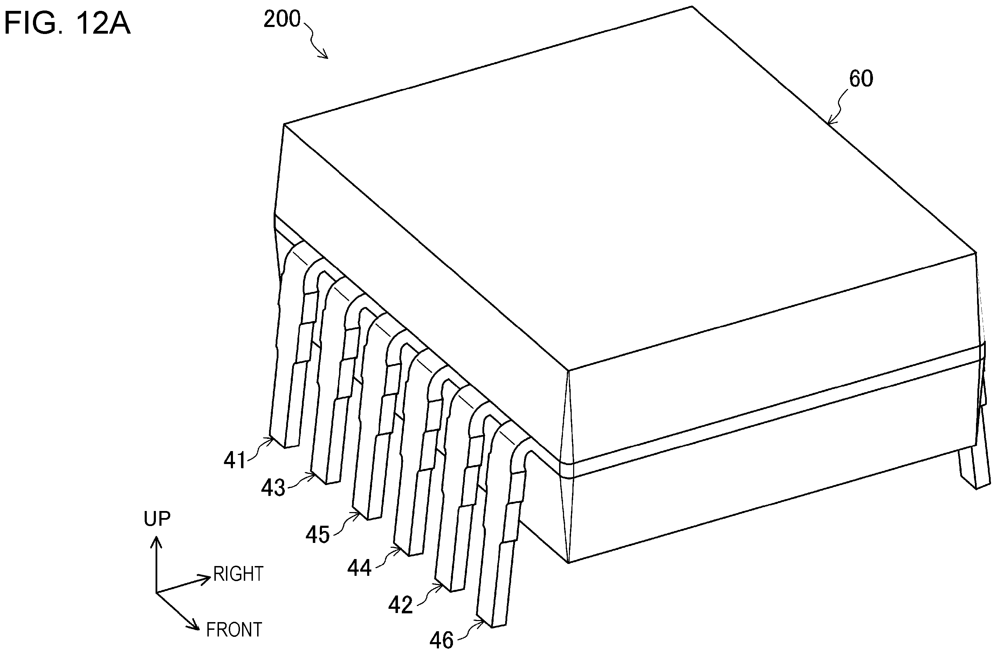

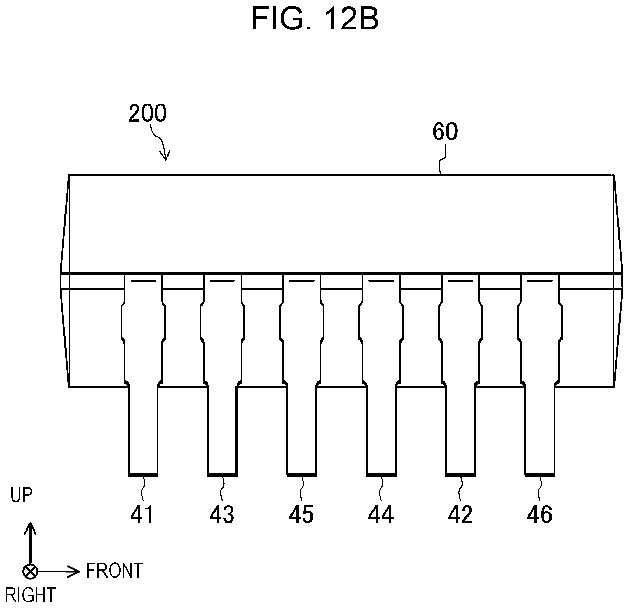

Fig. 12A is an oblique projection of a semiconductor relay according to a variation. Fig. 12B is a side view of the semiconductor relay according to the variation.

As in the present variation, semiconductor relay 200 may be an insertion-mount type that is inserted into and mounted onto external mounting board 500. In the present variation, leading end portions 41a to 48a run along the side surface of package 60 and extend parallel to said side surface outward of package 60. Note that although not illustrated in the drawings, the internal structure of package 60 in semiconductor relay 200 according to the present variation is substantially the same as that described in Embodiment 1.

The present variation provides advantageous effects substantially the same as those obtained using the elements described in Embodiment 1. Specifically, when first and second die pads 51, 52 are provided, the heat generated by first and second switching elements 31, 32 and light-emitting element 10 during the operation of semiconductor relay 200 can be efficiently absorbed and transferred to the outside of package 60. In other words, the path for dissipating the heat generated during the operation of semiconductor relay 200 to the outside of package 60 can be enhanced, allowing for improved heat dissipation.

Note that an element of the surface-mount type typically contacts external mounting board 500 in a greater area and provides higher heat dissipation than an element of the insertion-mount type. Thus, semiconductor relay 200 of the insertion-mount type described in the present variation provides lower heat dissipation than semiconductor relay 100 according to Embodiment 1.

### (Embodiment 2)

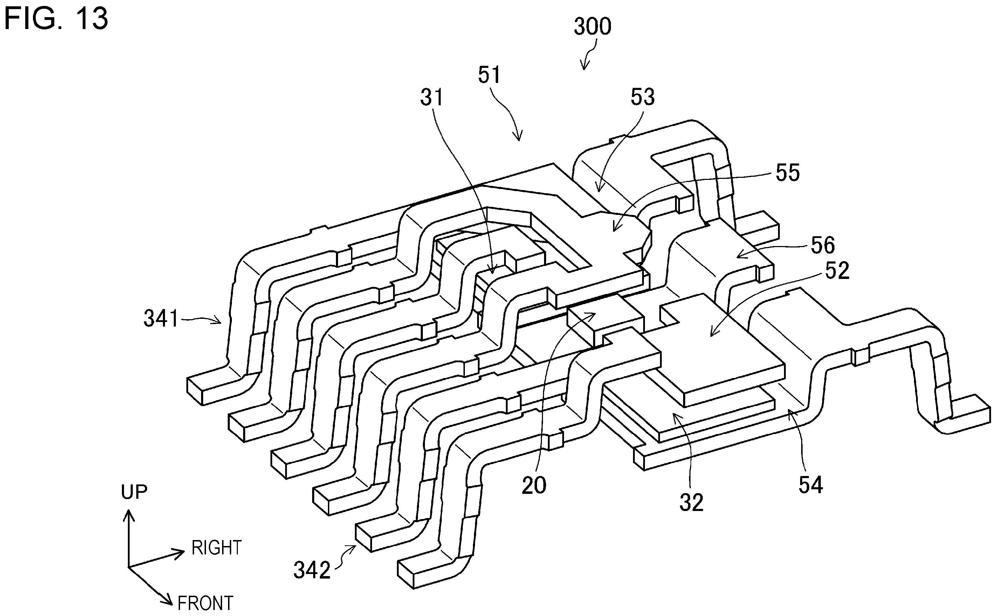

Fig. 13 is an oblique projection of a semiconductor relay according to Embodiment 2, with the package removed.

First terminal 341 and second terminal 342 in semiconductor relay 300 according to Embodiment 2 are different from first terminal 41 and second terminal 42 in semiconductor relay 100 according to Embodiment 1, respectively. Except for this point, the external appearance of semiconductor relay 300 including package 60 and the configuration and arrangement of the components located inside package 60 are substantially the same as those in semiconductor relay 100.

As illustrated in Fig. 13, first terminal 341 is drawn out of package 60 from the portion of package 60 that is located in the middle in the up-down direction, is bent, extends downward along the side surface of package 60, is further bent, and extends approximately parallel to and along the lower surface of package 60. Inside package 60, first terminal 341 is not bent and extends approximately parallel to the upper surface of package 60. Second terminal 342 has substantially the same shape as first terminal 341.

In the present exemplary embodiment, the distance between first die pad 51 and third die pad 53 is shorter than the distance between fifth die pad 55 and sixth die pad 56, as compared to the case described in Embodiment 1. The distance between second die pad 52 and fourth die pad 54 is shorter than the distance between fifth die pad 55 and sixth die pad 56.

With this configuration, the distance between first switching element 31 and first die pad 51 is shorter than that in Embodiment 1. When first switching element 31 generates heat, the heat is diffused into the surroundings through the nearby resin. A reduced distance between first switching element 31 and first die pad 51 allows for increased heat conduction from first switching element 31 to first die pad 51. In particular, this effect is pronounced when the components of semiconductor relay 300 are encapsulated by the resin because the resin has low thermal conductivity. As just described, in the present exemplary embodiment, first die pad 51 can more efficiently absorb the heat generated by first switching element 31, as compared to the case described in Embodiment 1, and allows the heat to be transferred to the outside of package 60 through first terminal 341.

In the present embodiment, the distance between second switching element 32 and second die pad 52 is shorter than that in Embodiment 1, as compared to the case described in Embodiment 1. When second switching element 32 generates heat, the heat is diffused into the surroundings through the nearby resin. A reduced distance between second switching element 32 and second die pad 52 allows for increased heat conduction from second switching element 32 to second die pad 52. In particular, this effect is pronounced when the components of semiconductor relay 300 are encapsulated by the resin because the resin has low thermal conductivity. As just described, in the present exemplary embodiment, second die pad 52 can more efficiently absorb the heat generated by first switching element 31, as compared to the case described in Embodiment 1, and allows the heat to be transferred to the outside of package 60 through second terminal 342.

Thus, the path for dissipating the heat generated during the operation of semiconductor relay 300 to the outside of package 60 can be enhanced, allowing for improved heat dissipation.

Note that similar to terminal 341, terminals 43 to 46 may extend parallel to the upper surface of package 60 without being bent inside package 60.

### (Conclusion)

Semiconductor relay 100 according to the present disclosure includes the following features.

Semiconductor relay 100 according to the first aspect includes at least: light-emitting element 10; light-receiving element 20 located below light-emitting element 10 and facing light-emitting element 10; first switching element 31 located adjacent to light-receiving element 20; and second switching element 32 located adjacent to light-receiving element 20. Furthermore, semiconductor relay 100 includes: first die pad 51 located above first switching element 31; second die pad 52 located above second switching element 32; first terminal 41 including one end connected to first die pad 51; second terminal 42 including one end connected to second die pad 52; and package 60.

Light-receiving element 20 is located between first switching element 31 and second switching element 32. The direction in which first terminal 41 and second terminal 42 are arranged is defined as a first direction, the other end of first terminal 41 is exposed outside package 60 and extends downward from package 60, and the other end of second terminal 42 is exposed outside package 60 and extends downward from package 60. Light-emitting element 10, light-receiving element 20, first switching element 31, second switching element 32, first die pad 51, and second die pad 52 are located inside package 60, first die pad 51 at least partially overlaps first switching element 31 as viewed from above, and second die pad 52 at least partially overlaps second switching element 32 as viewed from above.

In semiconductor relay 100 according to the second aspect, maximum length L1 of first die pad 51 in the first direction is greater than maximum length L2 of first terminal 41 in the first direction, and maximum length L3 of second die pad 52 in the first direction is greater than maximum length L2 of second terminal 42 in the first direction.

In semiconductor relay 100 according to the third aspect, minimum distance W1 in the first direction between first die pad 51 and the second die pad is shorter than minimum distance W2 in the first direction between first terminal 41 and second terminal 42.

In semiconductor relay 100 according to the fourth aspect, first die pad 51 includes wide portion (width changing portion) 51a, and wide portion (width changing portion) 51a is configured such that a length of first die pad 51 in the first direction increases from a boundary between first terminal 41 and the first die pad toward an end of first die pad 51.

In semiconductor relay 100 according to the fifth aspect, when a direction that is perpendicular to the first direction and in which each of first terminal 41 and second terminal 42 projects is defined as a second direction (the left-right direction), first die pad 51 includes a projection that projects in the first direction or the second direction.

In semiconductor relay 100 according to the sixth aspect, the area of first die pad 51 that overlaps first switching element 31 is different from the area of second die pad 52 that overlaps second switching element 32 as viewed from above.

In semiconductor relay 100 according to the seventh aspect, first terminal 41 includes: first leading end portion 41a; first intermediate portion 41b connected to first leading end portion 41a and exposed outside package 60; and first connection portion 41c located inside package 60 and connecting first intermediate portion 41b and first die pad 51. Minimum length D1 of first connection portion 41c in the first direction is greater than maximum length D2 of first leading end portion 41a in the first direction. Second terminal 42 includes: second leading end portion 42a; second intermediate portion 42b connected to second leading end portion 42a and exposed outside package 60; and second connection portion 42c located inside package 60 and connecting second intermediate portion 42b and second die pad 52. Minimum length D1 of second connection portion 42c in the first direction is greater than maximum length D2 of second leading end portion 42a in the first direction.

In semiconductor relay 100 according to the eighth aspect, minimum length D3 of first intermediate portion 41b in the first direction is greater than maximum length D2 of first leading end portion 41a in the first direction, and minimum length D3 of second intermediate portion 42b in the first direction is greater than maximum length D2 of second leading end portion 42a in the first direction.

Semiconductor relay 100 according to the ninth aspect further includes: third die pad 53 on which first switching element 31 is disposed; fourth die pad 54 on which second switching element 32 is disposed; terminal 47 including one end connected to third die pad 53; and terminal 48 including one end connected to fourth die pad 54. Terminal 47 includes: leading end portion 47a; intermediate portion 47b connected to leading end portion 47a and exposed outside package 60; and connection portion 47c located inside package 60 and connecting intermediate portion 47b and first die pad 51. Minimum length D1 of connection portion 47c in the first direction is greater than maximum length D2 of leading end portion 47a in the first direction. Terminal 48 includes: leading end portion 48a; intermediate portion 48b connected to leading end portion 48a and exposed outside package 60; and connection portion 48c located inside package 60 and connecting intermediate portion 48b and second die pad 52. Minimum length D1 of connection portion 48c in the first direction is greater than maximum length D2 of leading end portion 48a in the first direction.

In semiconductor relay 100 according to the tenth aspect, minimum length D3 of intermediate portion 47b in the first direction is greater than maximum length D2 of leading end portion 47a in the first direction, and minimum length D3 of intermediate portion 48b in the first direction is greater than maximum length D2 of leading end portion 48a in the first direction.

Creepage distance W3 in the first direction between intermediate portion 47b and intermediate portion 48b is equal to the minimum distance in the first direction between leading end portion 47a and leading end portion 48a.

In semiconductor relay 200, leading end portions 41a to 48a run along the side surface of package 60 and extend parallel to said side surface outward of package 60; semiconductor relay 200 is an insertion-mount type that is inserted into and mounted onto external mounting board 500. Except for this, the configuration of semiconductor relay 200 is substantially the same as the configuration of semiconductor relay 100.

Semiconductor relay 300 includes: fifth die pad 55 having a lower surface on which light-emitting element 10 is disposed; and sixth die pad 56 having an upper surface on which light-receiving element 20 is disposed.

Except for this, the configuration of semiconductor relay 300 is substantially the same as the configuration of semiconductor relay 100. In semiconductor relay 300, the distance between first die pad 51 and third die pad 53 is shorter than the distance between fifth die pad 55 and sixth die pad 56, and the distance between second die pad 52 and fourth die pad 54 is shorter than the distance between fifth die pad 55 and sixth die pad 56.

In semiconductor relays 100, 200, 300, the path for dissipating the heat generated during the operation to the outside of package 60 can be enhanced, allowing for improved heat dissipation.

Note that the description in the specification of the present application has been made thus far using semiconductor relays 100, 200, 300 of the optical coupling type as an example, but this is not particularly limiting. The shapes, relative positions, etc., of first to sixth die pads 51 to 56, terminals 41 to 48, and the like may be applied to semiconductor relays of the magnetic coupling type, the capacity coupling type, and the like. Even in this case, the path for dissipating the heat generated during the operation to the outside of package 60 can be enhanced, allowing for improved heat dissipation of the semiconductor relay.

### Industrial Applicability

A semiconductor relay according to the present disclosure can provide improved heat dissipation by enhancing the path for dissipating the heat generated during the operation to the outside of the package; thus, the semiconductor relay according to the present disclosure is useful.

### Reference Signs List

- 10: light-emitting element
- 20: light-receiving element
- 21: photodiode array
- 22: control circuit
- 31: first switching element
- 32: second switching element
- 41: terminal (first terminal)
- 41a: leading end portion (first leading end portion)
- 41b: intermediate portion (first intermediate portion)
- 41c: connection portion (first connection portion)
- 42: terminal (second terminal)
- 42a: leading end portion (second leading end portion)
- 42b: intermediate portion (second intermediate portion)
- 42c: connection portion (second connection portion)
- 43: terminal
- 44: terminal
- 45: terminal
- 46: terminal
- 47: terminal (third terminal in claims)
- 47a: leading end portion (third leading end portion in claims)
- 47a1: first surface
- 47a2: second surface
- 47b: intermediate portion (third intermediate portion in claims)
- 47ba: first portion
- 47ba3: third surface
- 47ba4: fourth surface
- 47bb: second portion
- 47bb3: third surface
- 47bb4: fourth surface
- 47bc: third portion
- 47bc3: third surface
- 47bc4: fourth surface
- 47c: connection portion (third connection portion in claims)
- 48: terminal (fourth terminal in claims)
- 48a: leading end portion (fourth leading end portion in claims)
- 48a1: fifth surface
- 48a2: sixth surface
- 48b: intermediate portion (fourth intermediate portion in claims)
- 48ba: fourth portion
- 48ba3: seventh surface
- 48ba4: eighth surface
- 48bb: fifth portion
- 48bb3: seventh surface
- 48bb4: eighth surface
- 48bc: sixth portion
- 48bc3: seventh surface
- 48bc4: eighth surface
- 48c: connection portion (fourth connection portion in claims)
- 51, 151: first die pad
- 51a, 151a: wide portion (width changing portion)
- 51b, 151b: projecting portion
- 52: second die pad
- 53: third die pad
- 54: fourth die pad
- 55: fifth die pad
- 56: sixth die pad
- 60: package
- 100: semiconductor relay
- 200: semiconductor relay
- 300: semiconductor relay
- 341: first terminal
- 342: second terminal
- 500: external mounting board
- 501: main board
- 502: wire
- 502a: land
- 503: ground electrode

## Claims

1. A semiconductor relay comprising:
a light-emitting element;
a light-receiving element located below the light-emitting element and facing the light-emitting element;
a first switching element located adjacent to the light-receiving element;
a second switching element located adjacent to the light-receiving element;
a first die pad located above the first switching element;
a second die pad located above the second switching element;
a first terminal including one end connected to the first die pad;
a second terminal including one end connected to the second die pad; and
a package, wherein
the light-receiving element is located between the first switching element and the second switching element,
a direction in which the first terminal and the second terminal are arranged is defined as a first direction,
an other end of the first terminal is exposed outside the package and extends downward from the package,
an other end of the second terminal is exposed outside the package and extends downward from the package,
the light-emitting element, the light-receiving element, the first switching element, the second switching element, the first die pad, and the second die pad are located inside the package,
the first die pad at least partially overlaps the first switching element as viewed from above, and
the second die pad at least partially overlaps the second switching element as viewed from above.

2. The semiconductor relay according to claim 1, wherein
a maximum length of the first die pad in the first direction is greater than a maximum length of the first terminal in the first direction, and
a maximum length of the second die pad in the first direction is greater than a maximum length of the second terminal in the first direction.

3. The semiconductor relay according to claim 1 or 2, wherein
a minimum distance in the first direction between the first die pad and the second die pad is shorter than a minimum distance in the first direction between the first terminal and the second terminal.

4. The semiconductor relay according to any one of claims 1 to 3, wherein
the first die pad includes a width changing portion, and
the width changing portion is configured such that a length of the first die pad in the first direction increases from a boundary between the first terminal and the first die pad toward an end of the first die pad.

5. The semiconductor relay according to any one of claims 1 to 4, wherein
when a direction that is perpendicular to the first direction and in which each of the first terminal and the second terminal projects is defined as a second direction,
the first die pad includes a projection that projects in the first direction or the second direction.

6. The semiconductor relay according to any one of claims 1 to 5, wherein
an area of the first die pad that overlaps the first switching element is different from an area of the second die pad that overlaps the second switching element as viewed from above.

7. The semiconductor relay according to any one of claims 1 to 6, wherein
the first terminal includes:
a first leading end portion;
a first intermediate portion connected to the first leading end portion and exposed outside the package; and
a first connection portion located inside the package and connecting the first intermediate portion and the first die pad,
a minimum length of the first connection portion in the first direction is greater than a maximum length of the first leading end portion in the first direction,
the second terminal includes:
a second leading end portion;
a second intermediate portion connected to the second leading end portion and exposed outside the package; and
a second connection portion located inside the package and connecting the second intermediate portion and the second die pad, and
a minimum length of the second connection portion in the first direction is greater than a maximum length of the second leading end portion in the first direction.

8. The semiconductor relay according to claim 7, wherein
a minimum length of the first intermediate portion in the first direction is greater than the maximum length of the first leading end portion in the first direction, and
a minimum length of the second intermediate portion in the first direction is greater than the maximum length of the second leading end portion in the first direction.

9. The semiconductor relay according to any one of claims 1 to 8, further comprising:
a third die pad on which the first switching element is disposed;
a fourth die pad on which the second switching element is disposed;
a third terminal including one end connected to the third die pad; and
a fourth terminal including one end connected to the fourth die pad, wherein
the third terminal includes:
a third leading end portion;
a third intermediate portion connected to the third leading end portion and exposed outside the package; and
a third connection portion located inside the package and connecting the third intermediate portion and the third die pad,
a minimum length of the third connection portion in the first direction is greater than a maximum length of the third leading end portion in the first direction,
the fourth terminal includes:
a fourth leading end portion;
a fourth intermediate portion connected to the fourth leading end portion and exposed outside the package; and
a fourth connection portion located inside the package and connecting the fourth intermediate portion and the fourth die pad, and
a minimum length of the fourth connection portion in the first direction is greater than a maximum length of the fourth leading end portion in the first direction.

10. The semiconductor relay according to claim 9, wherein
a minimum length of the third intermediate portion in the first direction is greater than the maximum length of the third leading end portion in the first direction, and
a minimum length of the fourth intermediate portion in the first direction is greater than the maximum length of the fourth leading end portion in the first direction.

11. The semiconductor relay according to claim 9 or 10, wherein
the third intermediate portion includes:
a first portion connected to the third connection portion; and
a second portion extending downward from the first portion, and
when a direction in which the light-emitting element and the light-receiving element face each other is defined as a third direction,
a first axis is more distant from the fourth terminal than a second axis, the first axis being a center line of the first portion that extends in the third direction, the second axis being a center line of the third leading end portion that extends in the third direction.

12. A semiconductor relay comprising:
a light-emitting element;
a light-receiving element located below the light-emitting element and facing the light-emitting element;
a first switching element located adjacent to the light-receiving element;
a second switching element located adjacent to the light-receiving element;
a first die pad located above the first switching element;
a second die pad located above the second switching element;
a first terminal including one end connected to the first die pad;
a second terminal including one end connected to the second die pad; and
a package, wherein
the light-receiving element is located between the first switching element and the second switching element,
a direction in which the first terminal and the second terminal are arranged is defined as a first direction,
an other end of the first terminal is exposed outside the package and extends downward from the package,
an other end of the second terminal is exposed outside the package and extends downward from the package,
the first die pad at least partially overlaps the first switching element as viewed from above,
the second die pad at least partially overlaps the second switching element as viewed from above,
the semiconductor relay further comprises:
a third die pad on which the first switching element is disposed;
a fourth die pad on which the second switching element is disposed;
a third terminal including one end connected to the third die pad; and
a fourth terminal positioned facing the third terminal in the first direction,
the light-emitting element, the light-receiving element, the first switching element, the second switching element, and the first to third die pads are located inside the package,
the third terminal includes:
a third leading end portion;
a third intermediate portion connected to the third leading end portion and exposed outside the package; and
a third connection portion located inside the package and connecting the third intermediate portion and the third die pad,
the third intermediate portion includes:
a first portion connected to the third connection portion; and
a second portion extending downward from the first portion, and
when a direction in which the light-emitting element and the light-receiving element face each other is defined as a third direction,
a minimum length of the third intermediate portion in the first direction is greater than a maximum length of the third leading end portion in the first direction, and
a first axis is more distant from the fourth terminal than a second axis, the first axis being a center line of the first portion that extends in the third direction, the second axis being a center line of the third leading end portion that extends in the third direction.

13. The semiconductor relay according to claim 12, wherein
the third leading end portion includes:
a first surface facing the fourth terminal; and
a second surface that is more distant in the first direction from the fourth terminal than the first surface,
the third intermediate portion includes:
a third surface facing the fourth terminal; and
a fourth surface that is more distant in the first direction from the fourth terminal than the third surface, and
the first surface is flush with the third surface.

14. The semiconductor relay according to claim 13, wherein
the third surface of the first portion is flush with the third surface of the second portion.

15. The semiconductor relay according to claim 13 or 14, wherein
the fourth surface of the first portion is flush with the fourth surface of the second portion.

16. The semiconductor relay according to any one of claims 9 to 15, further comprising:
a fifth die pad having a lower surface on which the light-emitting element is disposed; and
a sixth die pad having an upper surface on which the light-receiving element is disposed, wherein
a distance between the first die pad and the third die pad is shorter than a distance between the fifth die pad and the sixth die pad, and
a distance between the second die pad and the fourth die pad is shorter than the distance between the fifth die pad and the sixth die pad.
